# FASCICULE DE BREVET EUROPEEN

(11) **EP 0 838 824 B1**
(45) Date de publication et mention de la délivrance du brevet: **11.12.2002**
(21) Numéro de dépôt: 97402429.1
(22) Date de dépôt: 15.10.1997
(51) Int. Cl.: G11C 7/00, G11C 16/06

(54) **Mémoire à temps de lecture amélioré**
Speicher mit verbesserter Lesezeit
Memory with improved reading time

(30) Priorité: 25.10.1996 FR 9613080
(43) Date de publication de la demande: 29.04.1998
(73) Titulaire: STMicroelectronics S.A., 92120 Montrouge (FR)
(72) Inventeur: Devin, Jean, 75116 Paris (FR)
(74) Mandataire: Schmit, Christian Norbert Marie

(56) Documents cités:
- EP-A- 0 145 488
- EP-A- 0 422 939
- EP-A- 0 526 433
- EP-A- 0 660 333
- US-A- 5 029 135
- PATENT ABSTRACTS OF JAPAN vol. 018, no. 519 (P-1807), 29 septembre 1994 & JP 06 176583 A (TOSHIBA CORP), 24 juin 1994,

## Description

La présente invention a pour objet une mémoire à temps de lecture amélioré. Elle concerne plus particulièrement les mémoires de type non volatile dont les cellules mémoires comportent un transistor à grille flottante. Ces mémoires sont de type dit EPROM, ou bien EEPROM, ou bien même EPROM-FLASH selon le mode de programmation et le mode d'effacement retenu pour les cellules mémoires. Un exemple de ce type de mémoire est par exemple décrit dans la demande de brevet FR-A-2 714 202. La durée habituelle de lecture élémentaire d'un bit ou d'un mot dans un telle mémoire est de l'ordre de 100 nanosecondes. Le but de l'invention est de permettre de réduire la durée d'une lecture élémentaire.

Le principe de la lecture des cellules mémoires comportant un transistor à grille flottante est le suivant. Dans la grille flottante du transistor sont stockées ou non des charges selon que le transistor est dit programmé ou effacé (ou l'inverse parce que d'une technologie à l'autre les appellations sont différentes). Dans un exemple les charges stockées sont des électrons. La grille flottante agit alors comme un générateur de potentiel. Lorsqu'on veut lire une cellule, on soumet les régions drain et source de ce transistor à une différence de potentiel suffisante et on applique sur la grille de commande du transistor à grille flottante une tension susceptible de le faire conduire. S'il n'y a pas de charges électriques stockées, le transistor se met à conduire. S'il y a des charges électrique stockées sur la grille flottante, la tension appliquée sur la grille de commande est insuffisante pour combattre le potentiel induit par la grille flottante et le transistor ne conduit pas. Un circuit de lecture comporte dans son principe un dispositif qui mesure la présence ou non de courant de conduction à travers le transistor. La détection ou non de ce passage de courant renseigne sur l'état binaire mémorisé dans la cellule mémoire.

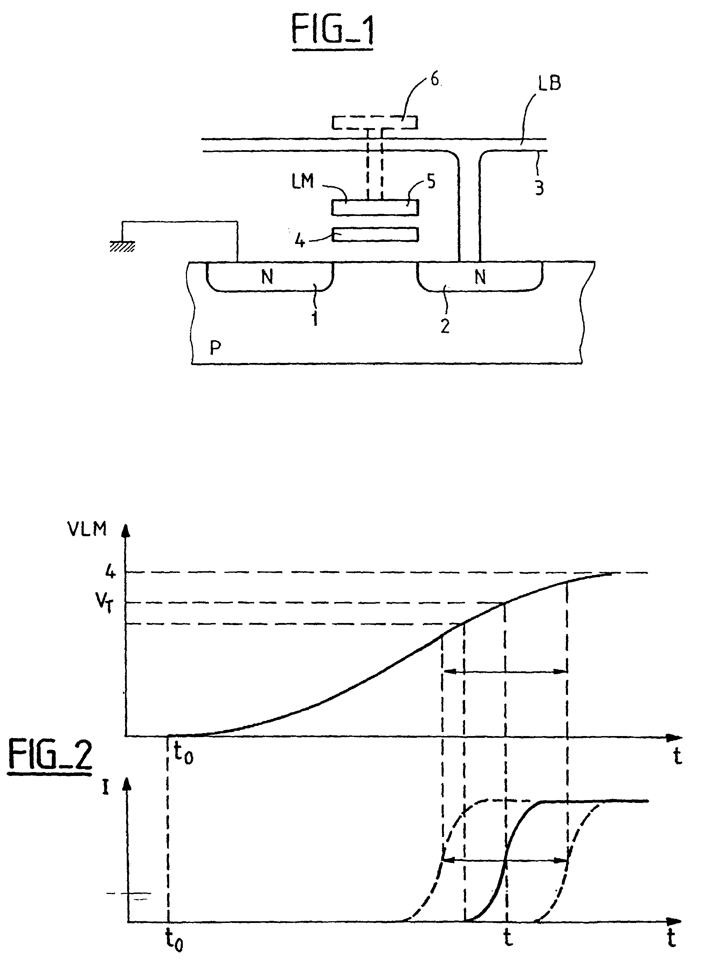

La figure 1 montre schématiquement une telle cellule mémoire avec un transistor à grille flottante. Ce transistor comporte une source 1 reliée à une masse et un drain 2 relié à une ligne de bits LB 3. La ligne 3 est reliée à un circuit de mesure de courant qui en pratique est un générateur de tension avec une forte impédance interne. Dès que le générateur débite, la tension sur la ligne 3 chute. Le transistor de la cellule mémoire comporte par ailleurs une grille flottante 4 et une grille de commande 5 superposée à la grille flottante 4 et jouant un rôle de ligne de mots LM. Le plan mémoire d'une mémoire comporte plusieurs cellules de ce type reliées matriciellement aux lignes de bits et aux lignes de mots.

En règle générale la ligne de bits est réalisée, au sommet du circuit intégré, par une ligne métallisée: elle est très peu résistive. En conséquence, la propagation de la tension de lecture sur une ligne de bits est très rapide. Par contre la ligne de mots 5 est constituée par une couche de polysilicium: elle est résistive. Même dans les cas où la ligne de mots est reprise de place en place par une ligne de mots métallisée 6, des sections en polysilicium de la ligne de mots sont quand même présentes et la ligne de mots reste plus résistive que la ligne de bits 3. Compte tenu des surfaces présentées par ces lignes de conduction vis à vis du plan mémoire, ces lignes sont capacitives. Comme la ligne de mots est plus résistive que la ligne de bits elle est plus lente à laisser s'installer la tension de lecture nécessaire.

Au moment de la lecture, les montées des différents potentiels sur les lignes doivent être synchronisées. Par exemple lors de la détection d'un signal de transition d'adresse, lorsqu'un nouveau mot ou une nouvelle cellule de la mémoire est adressé pour être lu, il ne sert à rien de préparer immédiatement le circuit de lecture connecté à la ligne de bits (préparation qui dure de l'ordre de 10 nanosecondes) si entre temps la ligne de mots met de l'ordre de 80 nanosecondes à être chargée.

La figure 2 montre par ailleurs le comportement d'un transistor à grille flottante d'une cellule mémoire dont la ligne de mots reçoit un potentiel VLM croissant lentement (toutes proportions gardées) à partir d'un instant t0 correspondant à une détection de transition d'adresse. Dans un exemple où le seuil VT de conduction d'un transistor à grille flottante est de l'ordre de 2 à 3 Volts, et où l'alimentation électrique du circuit intégré est de l'ordre de 5 Volts, on retient 4 Volts comme valeur nécessairement appliquée sur la grille de commande 4 pour faire conduire le transistor. Par exemple, la figure 2 montre que lorsque la tension appliquée vaut VT le courant I de conduction du transistor commence à croître. Il n'atteint une valeur significative que lorsque la tension sur la ligne de mots vaut environ 4 Volts. Il importe de connaître avec précision l'instant t auquel pour un circuit intégré donné cette lecture va être possible.

Malheureusement le temps t dépend très fortement du dessin des différents transistors, de l'historique des étapes du procédé qui a conduit à la fabrication du circuit intégré, ainsi que des conditions d'utilisation de ce circuit, notamment la valeur de la tension d'alimentation et la température d'utilisation. Par exemple il est connu que la valeur t varie très fortement, par exemple entre 50 nanosecondes pour un circuit naturellement rapide et 100 nanosecondes pour un circuit lent. La figure 2 montre les raisons de cette variation. Au moment où la cellule se met à conduire, où le courant I croît brutalement, la pente de croissance de la tension sur la ligne de mots est faible. En conséquence, il suffit d'un tout petit dérèglage de la polarisation de ces lignes de mots ou de conditions de fonctionnement des transistors à grille flottante pour que l'instant t de déclenchement montré par les pointillés varie beaucoup dans le temps.

Dans l'état de la technique pour remédier à ce problème, on a cherché, pour connaître t, à simuler le temps de montée des lignes de mots par une ligne de mots supplémentaire ou fausse ligne de mots. En pratique, la fausse ligne de mots a été simulée par un unique circuit de type RC. Pour néanmoins avoir des constantes de temps indépendantes de la température de la tension d'alimentation et du procédé de fabrication du circuit intégré, on a été conduit à réaliser des circuits de type BANDGAP ou avec des transistors bipolaires. Outre leur complexité ces circuits présentent l'inconvénient de consommer du courant en continu si on veut obtenir la rapidité. Malgré tout, on est quand même obligé de tenir compte des pires cas avec des circuits, c'est à dire des 100 nanosecondes.

Un autre problème survient par ailleurs. En effet, il est possible que le bus d'adresse connecté à la mémoire soit mal géré et délivre des fausses adresses, d'une manière anarchique, même pendant une certaine durée. Ces fausses adresses sont détectées par le circuit de détection de transition d'adresse et provoquent normalement la montée en tension de la fausse ligne de mots qui va servir à élaborer l'instant de déclenchement t, l'instant de synchronisation de la lecture. Lorsqu'il s'est agit d'une détection de transition d'adresse parasite, à une détection de transition d'adresse suivante, il faut rapidement décharger la fausse ligne de mots de la tension à laquelle elle était montée, puis recommencer à la charger vers sa tension nominale.

Il existe des solutions dans lesquelles la fausse ligne de mots de type RC est munie de plusieurs condensateurs répartis le long de la ligne et, pour la décharger, de plusieurs gros transistors de désélection en parallèle sur ces transistors. Ils permettent de remettre la fausse ligne de mots à zéro avant de faire remonter la tension. Dans un exemple on connaît des lignes de mots avec 1000 cellules sur lesquelles il faut 8 gros transistors séparant des groupes de 128 cellules. Cependant, la distribution de ces 8 gros transistors modifie la règle de dessin, le schéma des cellules n'est plus répétitif (il doit être modifié toutes les 128 cellules) et la réalisation du circuit intégré devient trop complexe.

En pratique on ne fait pas cela. Pour simplifier, on fait un circuit de type RC simple avec un seul transistor de désélection. Le problème rencontré dans ce cas est que le circuit de type RC a des caractéristiques qui bougent fortement avec la température et la tension d'alimentation. On est donc alors contraint de choisir pour ce circuit de type RC encore une fois un pire cas. Au bout du compte, on fait fonctionner la mémoire au ralenti.

Dans l'invention, on procède différemment et notamment on ne réalise pas de ligne de mots simulée ni de ligne de mots supplémentaire mais on se sert des lignes de mots existantes. Dans l'invention, au bout de chaque ligne de mots, on rajoute une cellule mémoire. L'ensemble des cellules mémoires ainsi rajoutées d'une manière supplémentaire en bout de chaque ligne de mots est organisée en une ligne de bits supplémentaire. On s'arrange en outre pour que les cellules mémoires supplémentaires de cette ligne de bits supplémentaire soient lues avant les cellules mémoires normale du plan mémoire normal. Et on utilise la date de leur lecture comme temps de déclenchement de la lecture. On montrera qu'il est très facile de provoquer, par exemple, une altération du fonctionnement de ces cellules mémoires supplémentaire de façon à ce que ces cellules soient lues avant les cellules mémoires du plan mémoire normal. Cette altération reste dépendante, dans de mêmes proportions, du procédé de fabrication, de la règle de dessin du circuit intégré, ainsi que des ses conditions d'utilisation. Il en résulte que si les caractéristiques du circuit intégré fabriqué sont dégradées, celles de la ligne de bits supplémentaire le sont proportionnellement de la même façon de sorte que le signal disponible sur celles-ci peut toujours être utilisée comme signal de déclenchement. On peut aussi dans le même esprit modifier le circuit de lecture de la ligne de bits supplémentaire pour arriver à un résultat comparable.

L'invention a donc pour objet une mémoire comportant:
- des cellules mémoires, avec chacune un transistor à grille flottante, reliées matriciellement à des lignes de bit et des lignes de mots,
- un circuit de décodage d'adresses pour imposer des potentiels de lecture sur au moins une ligne de bits et au moins une ligne de mots correspondant à une cellule à sélectionner, et pour imposer des potentiels différents sur les autres lignes de bits et lignes de mots,
- des circuits de lecture, chaque circuit de lecture étant relié à une ligne de bits pour mesurer un courant passant dans une des cellules reliées à cette ligne de bits,
- un circuit de déclenchement pour produire un signal de validation de la lecture à faire par les circuits de lecture,
- une ligne de bits supplémentaire, avec des cellules mémoires supplémentaires commandées par les lignes de mots de la mémoire,
- un circuit supplémentaire pour imposer un potentiel de lecture sur cette ligne de bits supplémentaire à chaque lecture,
- les transistors à grille flottante des cellules mémoires supplémentaires se trouvant dans un état de programmation qui provoque le passage d'un courant à travers eux quand leur cellule est sélectionnée,
- le circuit de lecture de cette ligne de bits supplémentaire produisant le signal de déclenchement,
caractérisée en ce que
- les transistors à grille flottante des cellules mémoires supplémentaires comportent des moyens dans leur canal de conduction pour conduire alors que le potentiel de lecture sur la ligne de mots n'a pas encore atteint une valeur nominale de conduction nécessaire pour la conduction des transistors des cellules mémoires de la mémoire.

Dans un exemple où la mémoire est de type EPROM, une grille de commande d'un transistor à grille flottante est reliée à une ligne de mots, une ligne de bits est reliée à une région drain ou source d'un transistor à grille flottante. Si la mémoire est de type EEPROM, une grille de commande d'un transistor de commande de la cellule est reliée à la ligne de mots, la région drain ou source du transistor de commande ou du transistor à grille flottante est reliée à la ligne de bits. La position de ces deux transistors peut en effet être inversée.

L'invention sera mieux comprise à la lecture de la description qui suit et à l'examen des figures qui l'accompagnent. Celles-ci ne sont données qu'à titre indicatif et nullement limitatif de l'invention. Les figures montrent:
- Figures 1 et 2: des représentations schématiques de fonctionnement de cellules mémoires avec transistor à grille flottante déjà commentées;
- Figure 3: une mémoire conforme à l'invention;
- Figure 4: des diagrammes temporels de signaux intervenant dans la mémoire de l'invention;
- Figure 5: l'allure d'un signal produit par un circuit de perfectionnement de l'invention.

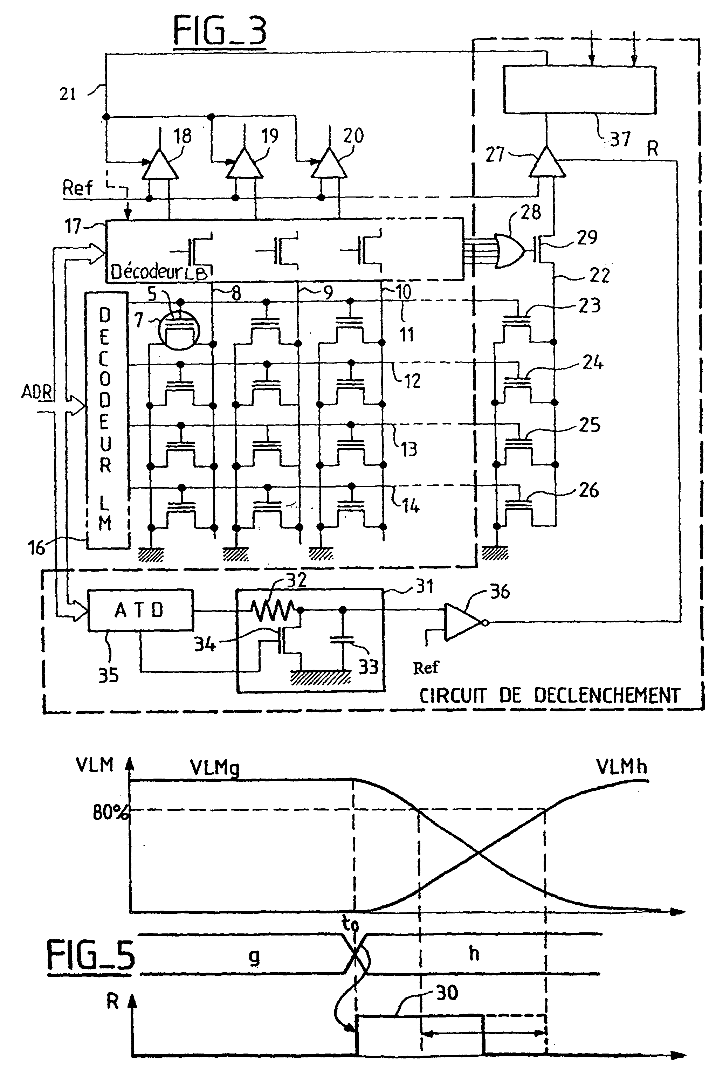

La figure 3 montre, dans le cas d'une mémoire EPROM, une mémoire munie de cellules mémoires telles que 7 comprenant chacune un transistor à grille flottante montré par ailleurs sur la figure 1. Ces cellules mémoires sont reliées matriciellement à des lignes de bits telles que 8 à 10 et à des lignes de mots telles que 11 à 14. Une grille de commande, par exemple la grille de commande 5 du transistor de la cellule 7 est commandée par une ligne de mots 11. Dans l'exemple montré sur la figure 3 la commande est directe: la grille de commande 5 est reliée à la ligne de mots 11. Cependant, pour des cellules mémoires de type EEPROM comportant un transistor de commande et le transistor à grille flottante proprement dit, la grille de commande du transistor de commande est reliée à la ligne de mots, la source du transistor de commande étant reliée à un drain du transistor à grille flottante, les deux transistors étant montés en série l'un avec l'autre, en dérivation sur la ligne de bits. La région drain ou source du transistor de la cellule 7 est par ailleurs reliée à une ligne de bits 8. Il s'agit d'une région drain ou source parce que ce type dépend de la technologie retenue.

Un circuit 16-17 de décodage d'adresse reçoit un signal d'adresse ADR et impose par un décodeur de lignes de mots 16 et un décodeur de lignes de bits 17 des potentiels de lecture sur au moins une ligne de bits et au moins une ligne de mots correspondant à une cellule à sélectionner. Sur les autres cellules non sélectionnées, le décodeur impose des autres tensions (généralement la masse) ou éventuellement relie les lignes non sélectionnées à un circuit à très haute impédance.

Les tensions de lecture peuvent varier selon l'architecture de la mémoire d'une part et selon la technologie mise en oeuvre d'autre part. Dans un exemple, celui représenté sur la figure 3, la tension à imposer sur une ligne de mots est de l'ordre de VCC (par exemple 5 Volts), et la tension à imposer sur une ligne de bits est du même ordre. Le décodeur 17 de lignes de bits a été représenté schématiquement comme comportant, en face de chaque ligne de bits, un transistor en série entre la ligne de bits concernée et un circuit de lecture. D'un côté les lignes de bits sont reliées aux cellules. A l'autre bout des lignes de bits 8 à 10 sont reliées respectivement à des circuits de lecture 18 à 20. Seule la ligne de bits qui est sélectionnée est reliée à son circuit de lecture par la mise en conduction du transistor correspondant.

Lorsque ces connections sont établies, les circuits de lecture 18 à 20 permettent de mesurer le courant qui passe dans une cellule sélectionnée. Dans ce but ces circuits sont généralement réalisé sous forme de circuits comparateurs (à base d'amplificateurs différentiels) mesurant la différence de tension entre un signal Ref disponible sur une entrée de référence d'une part et un signal disponible sur une entrée reliée à la ligne de bits d'autre part. Dans un exemple, la tension de référence est de l'ordre de la moitié de la tension de lecture (par exemple 2,5 Volts). Si le transistor à grille flottante de la cellule à lire n'est pas conducteur, la ligne de bits reste portée à sa tension de lecture (5 Volts) et le comparateur est dans un état donné. Par contre si ce transistor est conducteur, la ligne de bits se décharge, et le comparateur bascule.

La mémoire comporte par ailleurs un circuit de déclenchement représenté symboliquement ici par une connexion de commande 21 qui applique sur les circuits 18 à 20 un signal de déclenchement de lecture. Selon l'architecture retenue, la connexion 21 peut aussi être connectée au décodeur 17 pour en valider l'ultime fonctionnement. Eventuellement, la connexion 21 n'est pas reliée aux circuits de lecture mais au décodeur 17 seul. Dans un exemple, la ligne de bits étant préchargée, le circuit, dans les circuits de lecture 18-20 ou dans le décodeur 17, qui reçoit le signal transporté par la connexion 21 est un circuit de validation de fonctionnement. Il peut prendre la forme d'un transistor en série dans une ligne de transmission d'ordres.

Dans l'invention on a réalisé une ligne de bits supplémentaire 22 qui est connecté à des cellules mémoires supplémentaires ici 23 à 26. Les cellules 23 à 26 sont commandées par les lignes de mots 11 à 14, dans les mêmes conditions que les cellules mémoires du plan mémoire. Une borne des transistors à grille flottante de ces cellules est reliée à la masse, comme une borne des transistor à grille flottante des cellules du plan mémoire. Les cellules 23 à 26 présentent cependant la particularité d'être toutes dans un état de programmation qui provoque le passage du courant à travers elles à chaque fois que l'une d'entre elles est sélectionnée. Ainsi autant les cellules mémoires du plan mémoire peuvent avoir deux états électriques, autant les cellules 23 à 26 n'en auront qu'un, celui où le transistor à grille flottante est conducteur.

Ceci peut être obtenu de différentes façons. Par exemple, les cellules 23 à 26 ne comportent pas de transistor à grille flottante: le transistor est un transistor simple. Ou bien, en fabrication les transistors à grille flottante vierges des cellules supplémentaires sont modifiés pour être naturellement conducteurs.

La ligne de bits 22 est reliée à un circuit de lecture 27. Ce circuit de lecture 27 est sollicité à chaque lecture. Ceci est symbolisé par la présence d'une porte OU 28 agissant sur un transistor de connexion 29 qui met en relation la ligne de bits 22 avec le circuit de lecture 27 à chaque fois qu'un des fils du bus d'adresse au moins présente un état électrique 1. Pour simplifier l'explication, le circuit de lecture 27 reçoit également le signal de référence Ref sur une entrée de référence. Le signal délivré par le circuit de lecture 27 est le signal de déclenchement nécessaire pour la validation des circuits de lecture 18 à 20 ou même du décodeur 17.

On s'arrangera pour que le transistor, à grille flottante ou non, des cellules 23 à 26 devienne conducteur avant que ne devienne conducteur un transistor d'une cellule normale de la mémoire. Pour que les transistors 23 à 26 conduisent avant les transistors à grille flottante normaux du plan mémoire on peut employer plusieurs techniques. Dans une première technique, le canal de conduction de ces transistors (à grille flottante) est implanté avec des impuretés de type N en nombre suffisant pour avoir une tension de seuil plus faible. Dans une variante, la largeur de ce transistor sera plus grande qu'une largeur normale. La largeur est la dimension du canal du transistor perpendiculaire au plan de la figure 1. Dans une autre variante, le couplage entre la grille flottante 4 et la grille de commande 5 est modifiée de façon à ce que l'influence de la tension imposée sur la ligne de mots 5 soit plus forte. En pratique, dans ce cas, la grille flottante et la grille de commande s'étendent, dans le sens de la largeur du transistor, au dessus de zones en oxyde épais qui séparent les cellules mémoires les unes des autres. De cette façon, on augmente le rapport de la capacité entre grilles à la capacité entre grille flottante et canal de conduction du transistor. Dans une troisième variante, les transistors 23 à 26 possèdent, comme les transistors du plan mémoire des circuits pour être programmés ou effacés et on les programme, ou on les efface (selon la technologie retenue), à une valeur inférieure à celle retenue pour les autres transistors du plan mémoire.

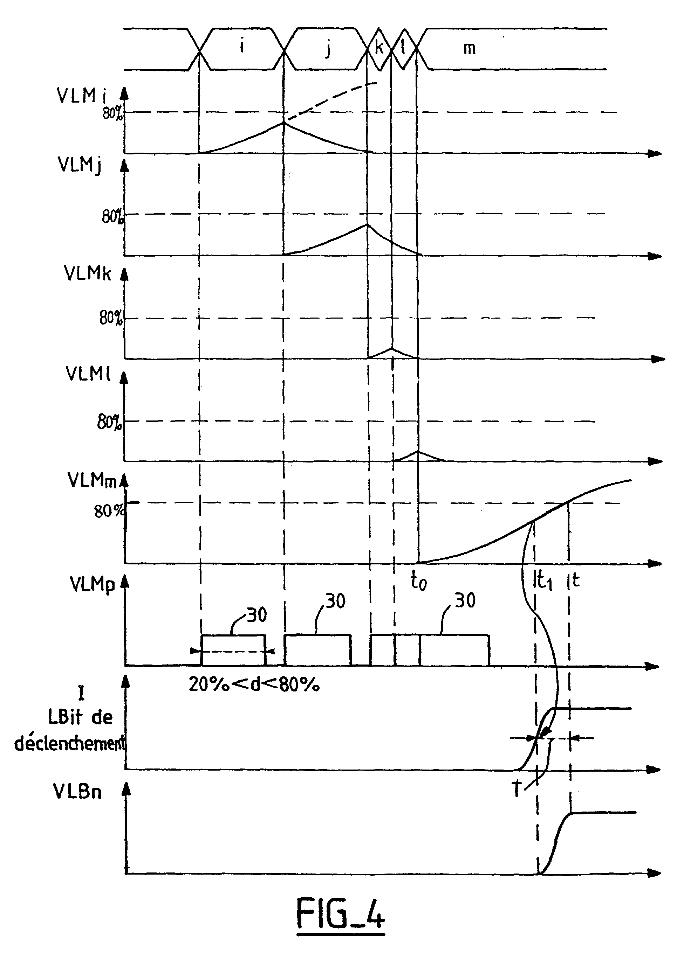

La figure 4 montre un diagramme temporel des tensions qui apparaissent dans différents endroits du plan mémoire de l'invention. En haut de la figure on a montré que des signaux d'adresse sont présents sur le bus d'adresse pour sélectionner une ligne de mots i puis les lignes de mots j, k, l, et m. Les diagrammes situés en dessous montrent l'établissement des tensions sur des lignes de mots consécutivement à l'adressage de ces lignes de mots. A chaque fois on a fait figurer en tirets une courbe à 80% au-delà de laquelle les cellules normalement programmées devraient se mettre à conduire.

Les fonctionnements erratiques de la figure 4 (adressages de durées insuffisantes) indiquent la présence d'une adresse pendant 40 nanosecondes sur la ligne de mots i, 30 nanosecondes sur la ligne de mots j et montrent des oscillations d'adresse entre les lignes k, l et m. En aucun cas la durée de présence de ces adresses sur le bus d'adresse n'est suffisante pour que la tension disponible sur la ligne de mots i, j, k ou l n'atteigne les 80%.Par contre pour la ligne de mots m, cette tension est atteinte à une date t. Dans l'invention, on s'arrange pour qu'une des cellules 23 à 26 qui est située sur la même ligne de mots que la ligne de mots m se mette à conduire à une date t1, antérieure à t. L'avant dernier diagramme montre l'écart T de dates de conduction entre cette cellule sur la ligne de bits supplémentaire et la cellule sélectionnée. Cet écart T est maîtrisable par les modifications indiquées préalablement: canal de conduction déplété, géométrie différente de transistor, grille flottante ou niveau de programmation différent.

La particularité de réalisation de l'invention est que la durée T qui sépare les instants t1 et t est indépendante des fluctuations du procédé de fabrication, de la règle de dessin, et des conditions d'utilisation: température, tension d'alimentation. L'instant t1 peut donc être utilisé comme signal de déclenchement de la lecture proprement dite. Dans le dernier diagramme on montre que la tension VLBn sur la ligne de bits n qui serait adressé commence à croître à l'instant t1 et atteint rapidement son niveau de lecture (5 à 10 ns) avant même que la tension sur la ligne de mots m atteigne 80 %.

La figure 5 montre ce qui se passe pour des lignes de mots g et h lorsqu'un signal de changement d'adresse se produit à l'instant t0 pour passer de l'une à l'autre. La tension VLMg préalablement disponible sur la ligne de mots g commence à décroître à l'instant t0 alors que la tension VLMh commence à croître sur la ligne de mots h. La décroissance de VLMg est due à une connexion à la masse d'une extrémité de la ligne g. Il importe d'empêcher la lecture de la mémoire tant que la tension sur la ligne de mots g n'est pas redescendue au-delà de 80% de la tension nominale appliquée sur la ligne de mots pour la lecture (sinon on pourrait lire la ligne g alors qu'on veut lire la ligne h). Dans l'invention, on réalise cet empêchement en créant un circuit d'inhibition 31 qui neutralise le circuit de lecture 27 pendant une durée calibrée 30 après chaque transition d'adresse. Cette durée doit être supérieure au temps pendant lequel une décroissance de 20% de la tension VLMg se produit. Cette durée d'une décroissance de 20% est par ailleurs sensiblement la même qu'une durée nécessaire pour une croissance de 20% du signal VLMh. Par ailleurs, le créneau 30 du signal d'inhibition doit avoir une durée inférieure à la durée au bout de laquelle la tension VLMh atteint 80% de sa valeur nominale.

Si en plus on veut que la durée T soit de l'ordre de 10 nanosecondes, il suffit que la durée du créneau 30 soit sensiblement égale à 50% du temps de montée de la tension sur la ligne de mots. La précision requise pour cette durée d'inhibition est faible. La durée doit être comprise entre 20% et 80% de ce temps de montée. En toute rigueur elle doit être inférieure à la durée à 80% - T. Mais cette durée à 80 % et surtout la durée T peuvent être modifiées. Par exemple on peut ne pas déclencher la précharge des lignes de bits par la date t1. La date t1 peut n'être, par exemple, qu'une confirmation de la validité de la lecture. Dans ce cas la durée T peut être proche de zéro. Dans ces conditions, on peut se satisfaire sans difficulté d'un circuit de type RC 31, visible sur la figure 3, pour produire le créneau 30. Le circuit 31 comporte une résistance 32 en série avec un condensateur 33 lui-même en parallèle avec un transistor de remise à zéro 34.

Lorsqu'un circuit 35 de détection de transition d'adresse connecté en entrée au circuit 31, effectue une détection, ce circuit 35 produit deux signaux. Il produit premièrement une impulsion appliquée à la grille de commande du transistor 34, ce qui a pour effet de décharger rapidement le circuit 31. Deuxièmement il produit un signal de tension maintenu (par exemple VCC) pendant la durée de la présence de l'adresse. Le signal maintenu est appliqué au circuit RC et charge petit à petit le condensateur 33. La tension du point milieu du circuit RC monte lentement. Le point milieu du circuit RC, sortie du circuit 31, est reliée à un comparateur 36 qui reçoit par ailleurs le signal de référence Ref (ou un autre, équivalent). Le comparateur 36 produit un signal R (figure 5) avec un créneau, avant son basculement, pendant la durée 30. Ce créneau est appliqué sur une entrée d'inhibition ou de remise à zéro du circuit de lecture 27. Celui-ci est inhibé tant que le créneau est actif. Le comparateur 36 bascule lorsque le point milieu du circuit 31 a atteint une valeur suffisante, c'est à dire approximativement lorsque la tension sur la ligne de mots atteint 50% de sa valeur nominale.

Le septième diagramme de la figure 4 montre le fonctionnement du circuit d'inhibition 31. Lorsque les adresses oscillent, comme pour les adresses k l m, le signal d'inhibition R reste actif, le circuit de lecture 27 ne peut jouer son rôle. Par contre, après une durée de créneau 30, après une date t0, le circuit 27 est en service et le signal de déclenchement peut être détecté à la date t1 par le circuit 27.

La figure 3 montre encore en aval du circuit 27, un circuit 37 susceptible de recevoir d'autres signaux que le signal de déclenchement en vue de provoquer le déclenchement définitif sur la connexion 21 des circuits de lecture 18 à 20. Dans un fonctionnement normal, ces autres signaux sont à l'état actif avant le signal délivré par le circuit 27, de sorte qu'on peut considérer que c'est vraiment celui-ci qui provoque la lecture.

## Revendications

1. Mémoire comportant:
- des cellules mémoires (7), avec chacune un transistor à grille flottante (5), reliées matriciellement à des lignes de bit (8-10) et des lignes de mots (11-14),
- un circuit de décodage d'adresses (16, 17) pour imposer des potentiels de lecture sur au moins une ligne de bits et au moins une ligne de mots correspondant à une cellule à sélectionner, et pour imposer des potentiels différents sur les autres lignes de bits et lignes de mots,
- des circuits de lecture (18-20), chaque circuit de lecture étant relié à une ligne de bits pour mesurer un courant passant dans une des cellules reliées à cette ligne de bits,
- un circuit de déclenchement (22-36) pour produire un signal de déclenchement de la lecture à faire par les circuits de lecture,
- une ligne de bits supplémentaire (22), avec des cellules mémoires supplémentaires (23-26) commandées par les lignes de mots de la mémoire,
- un circuit supplémentaire (28, 29) pour imposer un potentiel de lecture sur cette ligne de bits supplémentaire (22) à chaque lecture,
- les transistors à grille flottante des cellules mémoires supplémentaires (23-26) se trouvant dans un état de programmation qui provoque le passage d'un courant à travers eux quand leur cellule est sélectionnée,
- le circuit de lecture (27) de cette ligne de bits supplémentaire (22) produisant le signal de déclenchement,
**caractérisée en ce que**
- les transistors à grille flottante des cellules mémoires supplémentaires (23-26) comportent des moyens dans leur canal de conduction pour conduire alors que le potentiel de lecture sur la ligne de mots n'a pas encore atteint une valeur nominale de conduction nécessaire pour la conduction des transistors des cellules mémoires (7) de la mémoire.

2. Mémoire selon la revendication 1, **caractérisée en ce que** les transistors à grille flottante des cellules mémoires supplémentaires comportent une implantation déplétée de leur canal de conduction.

3. Mémoire selon l'une des revendications 1 à 2, **caractérisée en ce que**
- les transistors à grille flottante des cellules mémoires supplémentaires possèdent une géométrie différente de celle des transistors à grille flottante des cellules mémoires de la mémoire.

4. Mémoire selon l'une des revendications 1 à 3, **caractérisée en ce que**
- les transistors à grille flottante des cellules mémoires supplémentaires comportent une concentration de charges électriques stockées dans leur grille flottante différente de celle des transistors à grille flottante des cellules mémoires de la mémoire.

5. Mémoire selon l'une des revendications 1 à 4, **caractérisée en ce que**
- le circuit de déclenchement comporte un circuit pour invalider la transmission du signal de lecture de la ligne de bits supplémentaire.

6. Mémoire selon la revendication 5, **caractérisée en ce que**
- le circuit pour invalider produit un signal d'invalidation dont la durée est comprise entre 20 et 80 pourcents du temps de montée de la tension de ligne de mots.

7. Mémoire selon la revendication 5 ou la revendication 6, **caractérisée en ce que**
- le circuit pour invalider comporte un circuit RC.

8. Mémoire selon l'une des revendications 1 à 7, **caractérisée en ce que**:
- une grille de commande d'un transistor à grille flottante est commandée par une ligne de mots,
- une ligne de bits est reliée à une région drain ou source d'un transistor à grille flottante.

9. Mémoire selon l'une des revendications 1 à 7, **caractérisée en ce que**:
- une grille de commande d'un transistor de commande de la cellule est commandée par une ligne de mots,
- une ligne de bits est reliée à une région drain ou source d'un transistor à grille flottante ou du transistor de commande de cette cellule.

## Claims

1. Memory comprising:
- memory cells (7), each with a floating gate transistor (5), connected in matrix fashion to bit lines (8-10) and word lines (11-14),
- an address decoding circuit (16, 17) for imposing read potentials on at least one bit line and at least one word line corresponding to a cell to be selected, and for imposing different potentials on the other bit lines and word lines,
- read circuits (18-20), each read circuit being connected to a bit line in order to measure a current passing through one of the cells connected to this bit line,
- a triggering circuit (23-36) for producing a signal for triggering the reading to be carried out by the read circuits,
- a supplementary bit line (22), with supplementary memory cells (23-26) controlled by the word lines of the memory,
- a supplementary circuit (28, 29) for imposing a read potential on this supplementary bit line (22) at each reading,
- the floating gate transistors of the supplementary memory cells (23-26) being in a programming state which causes a current to pass through them when their cell is selected,
- the read circuit (27) of this supplementary bit line (22) producing the triggering signal,
**characterised in that**
- the floating gate transistors of the supplementary memory cells (23-26) comprise means in their conduction channel for conducting whilst the read potential on the word line has not yet attained a nominal conduction value necessary for the conduction of the transistors of the memory cells (7) of the memory.

2. Memory according to Claim 1, **characterised in that** the floating gate transistors of the supplementary memory cells comprise a depleted implantation of their conduction channel.

3. Memory according to one of Claims 1 to 2, **characterised in that**
- the floating gate transistors of the supplementary memory cells have a geometry different from that of the floating gate transistors of the memory cells of the memory.

4. Memory according to one of Claims 1 to 3, **characterised in that**
- the floating gate transistors of the supplementary cells have a concentration of electrical charges stored in their floating gate different from that of the floating gate transistors of the memory cells of the memory.

5. Memory according to one of Claims 1 to 4, **characterised in that**
- the triggering circuit comprises a circuit for disabling the transmission of the read signal for the supplementary bit line.

6. Memory according to Claim 5, **characterised in that**
- the circuit for disabling produces a disabling signal whose duration is between 20% and 80% of the word line voltage rise time.

7. Memory according to Claim 5 or Claim 6, **characterised in that**
- the circuit for disabling comprises an RC circuit.

8. Memory according to one of Claims 1 to 7, **characterised in that**:
- a control gate of a floating gate transistor is controlled by a word line,
- a bit line is connected to a drain or source region of a floating gate transistor.

9. Memory according to one of Claims 1 to 7, **characterised in that**:
- a control gate of a control transistor of the cell is controlled by a word line,
- a bit line is connected to a drain or source region of a floating gate transistor or of the control transistor of this cell.

## Patentansprüche

1. Speicher mit
- Speicherzellen (7), die jeweils einen Transistor mit floatendem Gate aufweisen, welche in Matrixform mit Bit-Leitungen (8-10) und Wort-Leitungen (11-14) verbunden sind,
- einem Adreßdecodierschaltkreis (16, 17), um Lesepotentiale auf wenigstens eine Bit-Leitung und wenigstens eine Wort-Leitung aufzuprägen, welche einer auszuwählenden Zelle entsprechen, und um auf die anderen Bit-Leitungen und Wort-Leitungen andere Potentiale aufzuprägen,
- Leseschaltkreisen (18-20), wobei jeder Leseschaltkreis mit einer Bit-Leitung verbunden ist, um einen Strom zu messen, der durch eine der Zellen geht, welche mit dieser Bit-Leitung verbunden sind,
- einem Auslöseschaltkreis (22-36) zum Erzeugen eines Auslösesignals zum Lesen mit den Leseschaltkreisen,
- einer zusätzlichen Bit-Leitung (22), wobei zusätzliche Speicherzellen (23-26) durch die Wort-Leitungen des Speichers gesteuert werden,
- einem zusätzlichen Schaltkreis (28, 29) zum Aufprägen eines Lesepotentials auf die zusätzliche Bit-Leitung (22) bei jedem Lesen,
wobei die Transistoren mit floatendem Gate der zusätzlichen Speicherzellen (23-26) sich in einem Programmierzustand befinden, der einen Strom durch sie hindurchgehen läßt, wenn ihre Zelle ausgewählt ist,
- wobei der Leseschaltkreis (27) dieser zusätzlichen Bit-Leitung (22) das Auslösesignal erzeugt, **dadurch gekennzeichnet, daß**
- die Transistoren mit floatendem Gate der zusätzlichen Speicherzellen (23-26) in ihrem leitenden Kanal Mittel aufweisen, welche bewirken, daß sie dann leiten, wenn das Lesepotential auf der Wort-Leitung noch keinen Nenn-Leitwert erreicht hat, der notwendig ist, damit die Transistoren der Speicherzellen (7) des Speichers leiten.

2. Speicher nach Anspruch 1, **dadurch gekennzeichnet, daß** die Transistoren mit floatendem Gate der zusätzlichen Speicherzellen eine Verarmungsimplantation ihres leitenden Kanals aufweisen.

3. Speicher nach einem der Ansprüche 1-2, **dadurch gekennzeichnet, daß** die Transistoren mit floatendem Gate der zusätzlichen Speicherzellen eine andere Geometrie als die Transistoren mit floatendem Gate der Speicherzellen des Speichers aufweisen.

4. Speicher nach einem der Anspüche 1-3, **dadurch gekennzeichnet, daß** die Transistoren mit floatendem Gate der zusätzlichen Speicherzellen eine elektrische Ladungskonzentration aufweisen, die in ihrem floatenden Gate gespeichert ist und sich von der der Transistoren mit floatendem Gate der Speicherzellen des Speichers unterscheidet.

5. Speicher nach einem der Ansprüche 1-4, **dadurch gekennzeichnet, daß** der Auslöseschaltkreis einen Schaltkreis zum Verhindern der Übertragung des Lesesignals von der zusätzlichen Bit-Leitung umfaßt.

6. Speicher nach Anspruch 5, **dadurch gekennzeichnet, daß** der Schaltkreis zum Verhindern ein Ungültig-Signal erzeugt, dessen Dauer zwischen 20 und 80 % der Anstiegszeit der Spannung der Wort-Leitung liegt.

7. Speicher nach Anspruch 5 oder Anspruch 6, **dadurch gekennzeichnet, daß** der Schaltkreis zum Verhindern eine RC-Schaltung umfaßt.

8. Speicher nach einem der Ansprüche 1-7, **dadurch gekennzeichnet, daß** ein Steuergate eines Transistors mit floatendem Gate über eine Wort-Leitung gesteuert wird,
eine Bit-Leitung mit einem Drain- oder Sourcebereich des Transistors mit floatendem Gate verbunden ist.

9. Speicher nach einem der Ansprüche 1-7, **dadurch gekennzeichnet, daß** ein Steuergate eines Steuertransistors der Zelle über eine Wort-Leitung gesteuert wird, eine Bit-Leitung mit einem Drain- oder Sourcebereich eines Transistors mit floatendem Gate oder des Steuertransistors dieser Zelle verbunden ist.
